# EUROPEAN PATENT SPECIFICATION

(11) **EP 0 525 651 B1**
(45) Date of publication and mention of the grant of the patent: **11.10.2000**
(21) Application number: 92112614.0
(22) Date of filing: 23.07.1992
(51) Int. Cl.: H01L 21/60, H01L 23/10

(54) **Package structure for one or more IC chips**
Packungsstruktur für integrierte Schaltungschips
Structure d'empaquetage pour un ou plusieurs circuits intégrés

(30) Priority: 24.07.1991 JP 20622491
(43) Date of publication of application: 03.02.1993
(73) Proprietor: NEC CORPORATION, Tokyo (JP)
(72) Inventor: Miyazaki, Hirokazu, Minato-ku, Tokyo (JP)
(74) Representative: VOSSIUS & PARTNER

(56) References cited:
- EP-A- 0 260 370
- US-A- 3 591 839
- PATENT ABSTRACTS OF JAPAN vol. 14, no. 564 (E-1013)14 December 1990 & JP-A-02 244 661 ( FUJITSU LTD ) 28 September 1990
- PATENT ABSTRACTS OF JAPAN vol. 8, no. 200 (E-266) 13 September 1984 & JP-A-59 088 864 ( MATSUSHITA DENKI SANGYO KK ) 22 May 1984
- PATENT ABSTRACTS OF JAPAN vol. 15, no. 135 (E-1052) 4 April 1991 & JP-A-03 016 159 ( SHINKO ELECTRIC IND CO LTD ) 24 January 1991
- PATENT ABSTRACTS OF JAPAN vol. 15, no. 464 (E-1137) 25 November 1991& JP-A-03 198 367 ( FUJITSU LTD ) 29 August 1991
- Microelectronics Packaging Handbook, Ed. R.Tummala et al., Van Nostrand 1989, pgs. 432-434,779-783,1183,1187

## Description

The present invention relates to a structure for packaging one or more IC (Integrated Circuit) chips for use in a data processing device or similar electronic device on a wiring substrate.

Packaging structures for IC chips are disclosed in "Silicones with Improved Thermal Conductivity for Thermal Management in Electronic Packaging" by Adam L. Peterson, in Proc. 40th Electronic Component Technology Conference, pp. 613-619, May, 1990 (referred to as Prior Art 1 hereinafter), "DESIGNING THE THERMAL CONDUCTION MODULE FOR THE IBM 3081 PROCESSOR" BY Bernard T. Clark, in Proc. International Microelectronic Conference, pp. 14 - 17, May, 1982 (referred to as Prior Art 2 hereinafyer), and JP-A-60-160150 (referred to as Prior Art 3 hereinafter).

Prior Art 1 and 2 each includes a wiring substrate having a wiring layer therein and pads and signal input and output pins on the bottom thereof. The pads and pins are electrically connected to the wiring layer. A bare chip is directly mounted on the top of the wiring substrate via bumps.

Prior Art 3 has a plurality of carriers each having a semiconductor device and a heat sink directly mounted on the top of the semiconductor device. The semiconductor device is hermetically sealed on a substrate by a cap. Such carriers are mounted on a single wiring substrate.

Prior Art 1, 2 and 3 described above have various problems left unsolved, as follows.

The problem with Prior Art 1 and 2 is that since the bare chip and wiring substrate are directly connected by the bumps, impurities such as dust are apt to deposit on the portion where the chip and substrate are connected and thereby short the circuitry, degrading the reliability of operation.

Further, Prior Art 1 and 2 lack a member for radiating head generated by the bare chip. Hence, the heat radiation efficiency is extremely low and cannot insure the expected operation when the temperature is high.

Prior Art 3 mounts a semiconductor device on a substrate to form a carrier and then mounts the carrier on a wiring substrate, as stated earlier. This brings about a problem that the substrate, as well as other associated elements, intervenes between the semiconductor device and the wiring substrate, increasing the distance of signal propagation. This increases the delay time particular to the propagation of electric signals and, therefore, prevents a required signal processing ability from being achieved.

JP-A-3016159 shows a semiconductor chip with solder frames and bumps, and a substrate with solder bonding pads, electrodes and through holes. After bonding operation, the through hole is sealed from the outside by using a solder. Therefore, connection parts of the semiconductor chip and the substrate are sealed hermetically from outside.

EP-A-260370 (forming the preamble of claim 1) shows a cap to provide a hermetic seal. The substrate, as well as other associated elements, intervene between the semiconductor device and the wiring substrate, which increases the distance of signal propagation and, thus, the delay time particular to the propagation of electric signals.

JP-A-59088864 shows projection films sealed with sealing metallic dams.

Microelectronics Packaging Handbook, edited by R. R. Tummala et al., published by Van Naestrand 1989, pages 432-434, 779-783, and 1147, discloses further details of semiconductor packaging structures.

It is therefore an object of the present invention is to provide a packaging structure for an IC chip or chips capable of enhancing the reliability of a portion where the chips and a wiring substrate are connected to each other. This object is solved with the features of claim 1.

The features and advantages of the present invention will become apparent from the following description when taken in conjunction with the accompanying drawings in which:
Figs. 1 to 3 and 5 are vertical sections respectively showing four illustrative embodiments of a packaging structure not forming part of the invention;
Fig 4 is a vertical section of a packaging structure in accordance with the present invention;
Fig. 6 is a vertical section representative of a conventional packaging structure;
Fig. 7 is a vertical section representative of another conventional packaging structure; and
Fig. 8 is an enlarged vertical section showing left part of the structure of Fig. 7.

In the figures, the same reference numerals designate the same or corresponding parts or elements.

To better understand the present invention, a brief reference will be made to conventional packaging structures for an IC chip or chips.

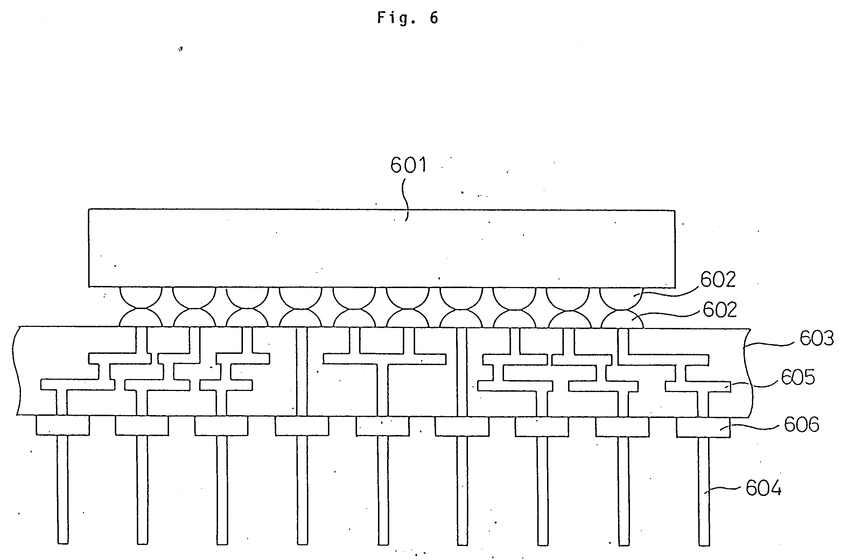

Referring to Fig. 6; a conventional IC chip packaging structure has a bare chip 601 and a wiring substrate 603. The wiring substrate 603 has at least one wiring layer 605, pads 606 connected to the wiring layer 605 via through holes, and signal input and output pins 604 affixed to the pad 606. Bumps 602 are provided on the bottom of the bare chip 601 and the top of the wiring substrate 603.

The bare chip 601 is directly affixed to a predetermined position on the top of the wiring substrate 603 by melting and then solidifying the bumps 602.

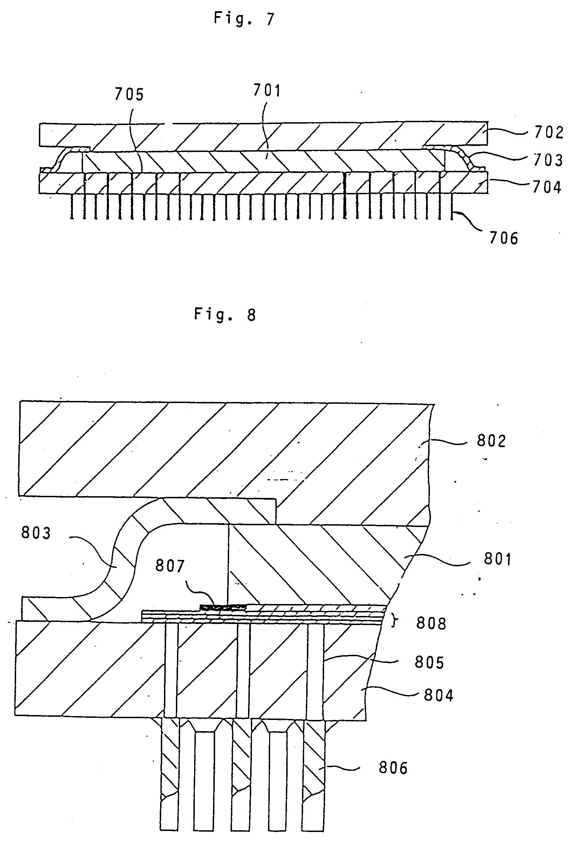

Fig. 7 shows another conventional packaging structure. As shown, the packaging structure is made up of at least one semiconductor device 701, a heat sink 702, a cap 703 for hermetically sealing the semiconductor device 701, a substrate 704 having via holes 705 thereinside, and input and output pins 706.

Left part of the structure shown in Fig. 7 is depicted in an enlarged view in Fig. 8. In Fig. 8, the semiconductor device, heat sink, cap, substrate, and signal input and output pins are respectively designated by the reference numerals 801, 802, 803, 804 and 806. The substrate 804 is formed with via holes 805. Leads 807 are associated with the signal input and output pins 806. A laminate wiring layer 808 is formed on the substrate 804 via a polyimide insulating layer.

Specifically, a great number of minute leads 807 are provided on the semiconductor device 801 and electrically connected to the associated pins 806 by the laminate wiring layer 808 and via holes 805. The cap 803 is soldered to the peripheral part of the top of the semiconductor device 801 and the substrate 804, thereby hermetically sealing the device 801. The heat sink 802 is directly soldered to the top of the semiconductor device 801.

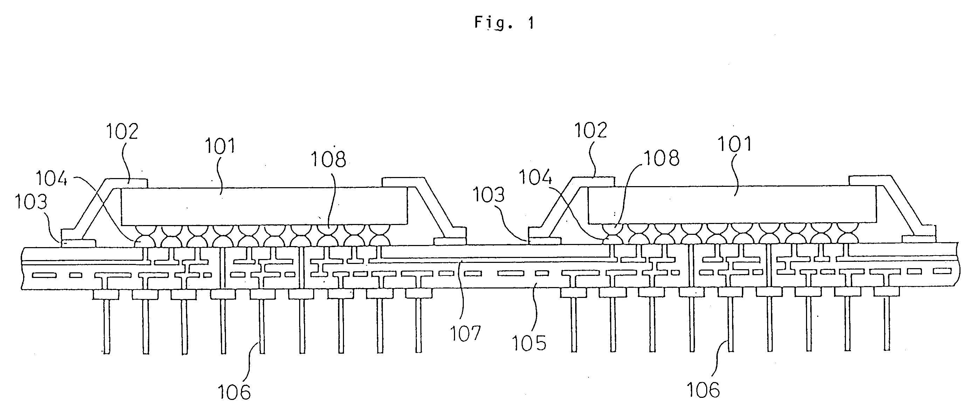

Referring to Fig. 1, a first illustrative embodiment of the packaging structure, not in accordance with the present invention, is shown. As shown, the structure includes a plurality of IC chips 101 each having a plurality of pads 108 thereon and each being hermetically sealed by a frame 102. A wiring substrate 105 is provided with pads 103 for the frames 102 and a plurality of bumps 104 on one major surface or top thereof allocated to the IC chips 101, and signal input and output pins 106 on the other major surface or bottom thereof. At least one wiring layer 107 is provided in the substrate 105 for electrically connecting the IC chips 101 or the IC chips and pins 106.

The bumps 104 provided on the top of the wiring substrate 105 and the pads provided on the bottom of the IC chips 101 are connected together by soldering, thereby mechanically and electrically connecting the chips 101 to the substrate 105.

The frames 102 are associated one-to-one with the IC chips 101, and each has the upper end connected to the periphery of the top of the associated chip 101 by, for example, Ag-containing solder. The lower end of each frame 102 is soldered to the associated pad 103 which surrounds the IC chip 101.

In the above configuration, the IC chips 101 are fully hermetically sealed by the wiring substrate 105 and respective frames 102. This noticeably enhances the reliability of the portion where the pads 108 and bumps 104 are connected together.

To further enhance the reliability of the above-mentioned connecting portion, the wiring substrate 105 and-IC chips 101 may be connected to each other in vacuum or in the N₂, Ar or similar inert gas atmosphere.

Since a substrate or similar object does not intervene between the IC chips 101 and the wiring substrate 105, the delay time particular to the propagation of electric signals is minimized. Hence, the embodiment allows signals to be processed at an extremely high speed, compared to the conventional structure wherein IC chips are hermetically sealed in respective chip carriers and mounted on a wiring substrate.

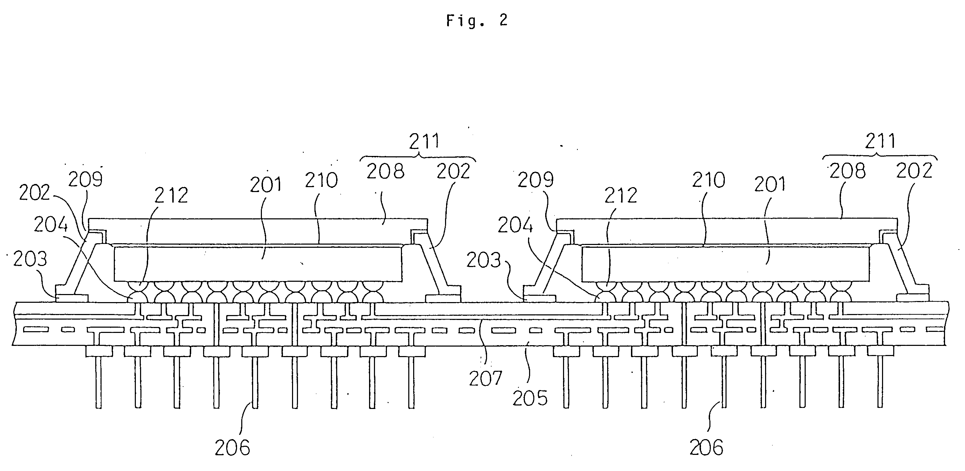

Fig. 2 shows a second illustrative embodiment. As shown, a plurality of IC chips 201 are each provided with a plurality of pads 212. A cap 211 is associated with each IC chip 201 and made up of a frame 202 and a heat sink 208. A wiring substrate 205 has pads 203 for the frames 202 and a plurality of bumps 204 on the top thereof where the IC chips 201 are mounted, and signal input and output pins 206 on the bottom thereof. At least one wiring layer 207 is provided in the wiring substrate 205 for electrically connecting the IC chips 201 or the IC chips 201 and pins 206.

In each cap 211, the heat sink 208 has a slightly greater area than the heat radiation surface of the IC chip 201 and is formed with grooves along the bottom edges thereof. The upper end of the frame 202 is received in the grooves of the heat sink 208 and connected to the latter by solder or similar bond 209. The cap 211 is directly connected to the heat radiation surface of the IC chip 201 by solder or similar bond 210. The lower end of the frame 202 is soldered to the associated pad 203 which surrounds the IC chip 201, thereby hermetically sealing the chip 201 in cooperation with the wiring substrate 205.

As stated above, the second embodiment bonds the cap 211, i.e., heat sink 208 directly to the top of the IC chip 201. Such a structure is successful in radiating heat generated by the IC chip 201 with utmost efficiency and, therefore, in noticeably enhancing the reliability of the IC chip 201. Of course, this embodiment also achieves the advantages described in relation to the first embodiment.

Further, since the caps 211 are associated one-to-one with the IC chips 201, the chips 211 can be repaired or replaced more easily than in the conventional packaging structures.

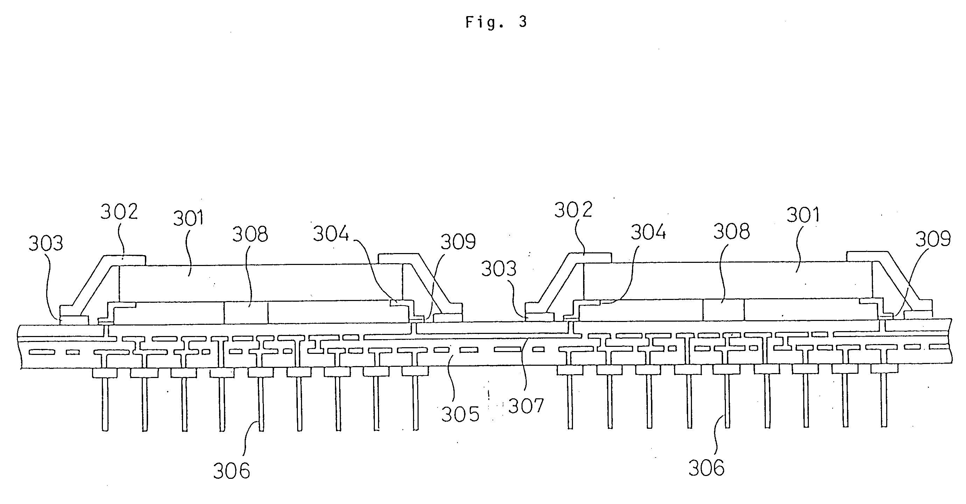

Referring to Fig. 3, a third illustrative embodiment includes a plurality of TAB (Tape Automated Bonding) chips 301 each having a plurality of leads 304. The chips 301 are hermetically sealed by respective frames 302. A wiring substrate 305 has pads 303 for the frames 302 and pads 309 for the leads 304 of the chips 301 on the surface thereof where the chips 301 are mounted, and signal input and output pins 306 on the other surface opposite to the chip mounting surface. A least one wiring layer 307 is provided in the substrate 305 for electrically connecting the chips 301 or the chips and pins 306. A rubber member 308 is interposed between the wiring substrate 305 and each chip 301.

The leads 304 of each chip 301 and the associated pads 309 of the wiring substrate 305 are connected together by soldering, setting up mechanical and electrical connection between the chip 301 and the substrate 305. The upper end of each frame 302 is connected to the periphery of the top of the associated chip 301 by, for example, Ag-containing solder. The lower end of the frame 302 is soldered to the associated pad 303 which surrounds the chip 301. In this configuration, the chip 301 is hermetically sealed by the frame 302 and wiring substrate 305. The rubber member 308 intervening between the chip 301 and wiring substrate 305 prevents excessive stresses from acting on the leads 304 during the operation for bonding the frame 302 to the chip 301 and substrate 305. If desired, the cap 211, Fig. 2, may be directly bonded to the top of each chip 301 in place of the frame 302.

The third embodiment having the above structure achieves the same advantages as those of the first and second embodiments. In addition, by using the chips 301, the embodiment allows the leads 304 of each chip 301 to easily absorb stresses ascribable to the difference in the coefficient of thermal expansion between the chip 301 and the wiring substrate 305. Furthermore, with the leads 304, the chips 301 are leveled in the direction of height.

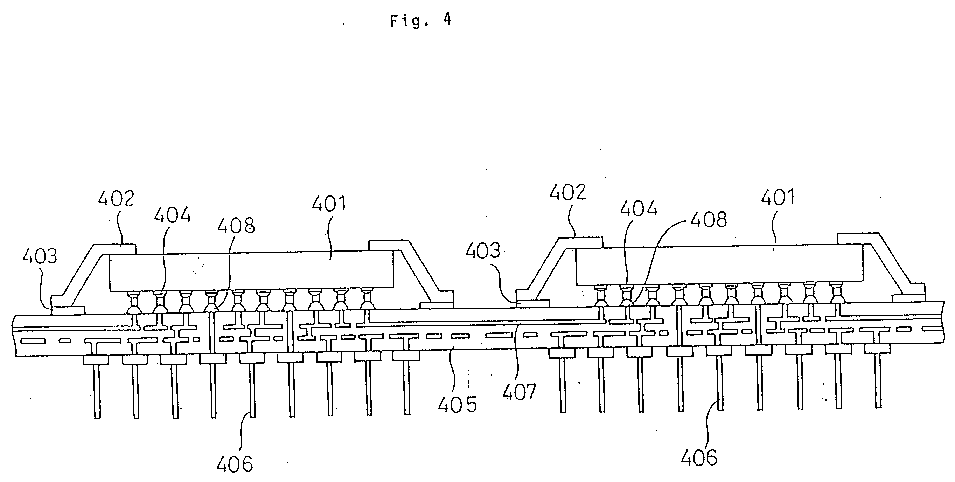

Fig. 4 shows an embodiment of the present invention including a plurality of IC chips 401 each having a plurality of minute pins 404. The IC chips 401 are hermetically sealed by respective frames 402. A wiring substrate 405 has pads 403 for the frames 402 and a plurality of bumps 408 on the surface thereof where the IC chips 401 are mounted, and signal input and output pins 406 on the other surface thereof opposite to the chip mounting surface. At least one wiring layer 407 is provided in the wiring substrate 405 for electrically connecting the IC chips 401 or the IC chips and the pins 406.

The pins 404 of each IC chip 401 may have a length of 1 mm and a diameter of 100 µm and are soldered to the bumps 408 of the wiring substrate 405 to connect the chip 401 and substrate 405 mechanically and electrically. Each frame 402 has the upper end thereof bonded to the periphery of the top of the associated IC chip 401 by, for example, Ag-containing solder and has the lower end soldered to the pad 403 which surrounds the chip 401. If desired, the cap 211, Fig. 2, may be connected to the top of each IC chip 401 by bond in place of the frame 402 of the illustrative embodiment.

The embodiment is comparable with the first and second illustrative embodiments in respect of some advantages. In addition, by using the minute pins 404, this embodiment easily reduces distortions ascribable to thermal stresses occurring the between the IC chips 401 and the wiring substrate 405 each of which has a particular coefficient of thermal expansion.

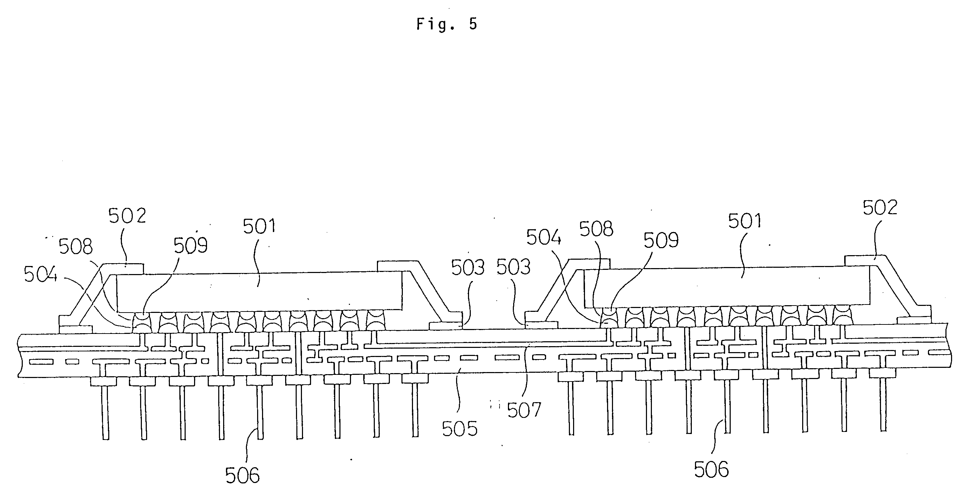

Referring to Fig. 5, a fourth illustrative embodiment will be described. As shown, a plurality of IC chips 501 each has a plurality of pads 509 on the bottom thereof, and each is hermetically sealed by a frame 502. A wiring substrate 505 has pads 503 for the frames 502 and a plurality of bumps 504 on the chip mounting surface thereof, and signal input and output pins 506 on the surface opposite to the chip mounting surface. At least one wiring layer 507 is provided in the substrate 505 for electrically connecting the IC chips 501 or the IC chips 501 and pins 506. The reference numeral 508 designates conductive bond.

The bumps 504 of the wiring substrate 505 and the pads 509 of the IC chips 501 are connected together by the conductive bond 508 to thereby connect the substrate 505 and chip 501 mechanically and electrically.

Each frame 502 has the upper end thereof connected to the periphery of the top of the IC chip 501 by, for example, Ag-containing solder and has the lower end connected to the pad 503 which surrounds the chip 501 by conductive bond. If desired, the cap 211, Fig. 2, may be bonded to the top of the IC chip 501 in place of the frame 502 of the illustrative embodiment.

This illustrative embodiment also achieves the advantages described in relation to the first and second illustrative embodiments. In addition, since the IC chips 501 and wiring substrate 505 are connected together by conductive bond, the connection can be effected at a lower temperature than with metallic solder, e.g., at 100°C. Hence, the illustrative embodiment simplifies a semiconductor device production line to a considerable degree while noticeably reducing the production cost.

While the present invention has been described in conjunction with the preferred embodiment thereof, it will now be readily possible for those skilled in the art to put this invention into practice.

## Claims

1. A packaging structure for one or more IC chips, comprising:
(a) at least one IC chip (401) having a plurality of chip terminals on a terminal surface of the chip;
(b) a wiring substrate (405) having on its mounting surface facing the IC chip terminal surface carrying the chip terminals (404) a plurality of substrate terminals (408) connected to said plurality of chip terminals (404), and a pad (403); and
(c) at least one frame (402) associated with and hermetically sealing said at least one IC chip (401), and connected at one end to the periphery of a top side of said IC chip (401) opposite to the terminal surface of the IC chip (401), and connected at the other end to said pad (403);
characterized in that
(d) the chip terminals comprise of minute pins (404) projecting essentially perpendicular from the IC chip terminal surface, and
(e) the substrate terminals are made of bumps (408).

2. The packaging structure of claim 1, comprising at least one cap (211) associated with and hermetically sealing said at least one IC chip (401) and comprising said frame (402) and a heat radiation member (208) connected to one end of said frame (402).

3. The packaging structure of claim 1 or 2, wherein said plurality of bumps (408) and said plurality of pins (404) are connected together by solder or conductive bond.

## Patentansprüche

1. Verpackungsstruktur für einen oder mehrere IC-Chips, mit:
(a) mindestens einem IC-Chip (401) mit mehreren Chipanschlüssen an einer Anschlußfläche des Chips;
(b) einem Verdrahtungssubstrat (405), das auf seiner Befestigungsoberfläche, die der Anschlußfläche des IC-Chips gegenüberliegt, welche die Chipanschlüsse (404) trägt, mehrere Substratanschlüsse (408), die mit den mehreren Chipanschlüssen (404) verbunden sind, und eine Kontaktfläche (403) aufweist; und
(c) mindestens einem Rahmen (402), der dem mindestens einen IC-Chip (401) zugeordnet ist und diesen hermetisch einschließt, und an einem Ende mit dem Umfang einer Oberseite des IC-Chips (401), die der Anschlußoberfläche des IC-Chips (401) gegenüberliegt, verbunden ist, und mit seinem anderen Ende mit der Kontaktfläche (403) verbunden ist;
dadurch gekennzeichnet, daß
(d) die Chipanschlüsse winzige Pins (404) aufweisen, welche im wesentlichen senkrecht aus der Anschlußfläche des IC-Chips hervorstehen, und
(e) die Substratanschlüsse aus Höckern (408) bestehen.

2. Verpackungsstruktur nach Anspruch 1, welche mindestens eine Kappe (211) aufweist, welche dem mindestens einen IC-Chip (401) zugeordnet ist und diesen hermetisch abdichtet, und den Rahmen (402) und ein Wärmeabstrahlungselement (208) aufweist, das mit einem Ende des Rahmens (402) verbunden ist.

3. Verpackungsstruktur nach Anspruch 1 oder 2, wobei die mehreren Höcker (408) und die mehreren Pins (404) miteinander durch Lötmittel oder leitende Bondung verbunden sind.

## Revendications

1. Structure d'empaquetage pour une ou plusieurs puces de circuit intégré, comprenant :
(a) au moins une puce de circuit intégré (401) ayant une pluralité de bornes de puce sur une surface de bornes de la puce ;
(b) un substrat de câblage (405) ayant, sur sa surface de montage faisant face à la surface de bornes de la puce de circuit intégré supportant les bornes de puce (404), une pluralité de bornes de substrat (408) connectée à ladite pluralité de bornes de puce (404) et un plot (403); et
(c) au moins un châssis (402) associé à et fermant hermétiquement ladite au moins une puce de circuit intégré (401) et connecté, à une extrémité, à la périphérie d'un côté supérieur de ladite puce de circuit intégré (401) opposé à la surface de bornes de la puce de circuit intégré (401), et connecté, à son autre extrémité, audit plot (403) ;
caractérisé en ce que
(d) les bornes de puce comprennent de minuscules broches (404) faisant saillie de manière essentiellement perpendiculaire depuis la surface de bornes de la puce de circuit intégré, et
(e) les bornes de substrat sont faites de bosses (408).

2. Structure d'empaquetage selon la revendication 1, comprenant au moins un chapeau (211) associé à et fermant hermétiquement ladite au moins une puce de circuit intégré (401) et comprenant ledit châssis (402) et un élément de rayonnement thermique (208) connecté à une extrémité dudit châssis (402).

3. Structure d'empaquetage selon la revendication 1 ou 2, dans laquelle ladite pluralité de bosses (408) et ladite pluralité de broches (404) sont connectées ensemble par soudure ou liaison conductrice.
